# EUROPÄISCHE PATENTSCHRIFT

(11) **EP 0 588 121 B1**
(45) Veröffentlichungstag und Bekanntmachung des Hinweises auf die Patenterteilung: **22.10.1997**
(21) Anmeldenummer: 93113715.2
(22) Anmeldetag: 27.08.1993
(51) Int. Cl.: H04H 1/00

(54) **RDS-Rundfunkempfänger mit Anordnung zum knackfreien Umschalten auf alternative Frequenzen**
RDS-broadcast receiver with a means for clickless change-over to alternative frequencies
Récepteur de radio diffusion-RDS avec un dispositif de commutation vers des fréquences alternatives pour éviter le grésillement

(30) Priorität: 17.09.1992 DE 4231121
(43) Veröffentlichungstag der Anmeldung: 23.03.1994
(73) Patentinhaber: GRUNDIG Aktiengesellschaft, 90762 Fürth (DE)
(72) Erfinder: Kalmer, Mathias, GRUNDIG E.M.V., D-90748 Fürth (DE)

(56) Entgegenhaltungen:
- EP-A- 0 415 132
- EP-A- 0 443 436
- WO-A-92/14312

## Beschreibung

Die Erfindung betrifft einen RDS-Rundfunkempfänger, insbesondere ein RDS-Autoradio, mit einer Einrichtung zum Auswerten von Mehrwegeempfangsstörungen und zum automatischen Umschalten auf eine alternative Empfangsfrequenz bei Verschlechterung der Empfangsverhältnisse.

Im Radio-Daten-System werden von den zugehörigen Sendestationen parallel zum laufenden Hörfunkprogramm digitale Daten ausgestrahlt, die einem Empfänger u.a. mit Hilfe sogenannter AF-Codes (AF = Alternative Frequencies) Hinweise geben, unter welchen Ersatzfrequenzen dasselbe Programm nochmals empfangen werden kann. Auf diese Weise können insbesondere mobile Empfangsgeräte bei Verschlechterung der Empfangsverhältnisse automatisch, ohne für den Gerätebenutzer hörbare Unterbrechung, auf eine alternative Frequenz mit guten Empfangseigenschaften umgeschaltet werden, so daß eine weitgehend ungestörte Tonwiedergabe gewährleistet ist. Einzelheiten der digitalen Datenübertragung sind der europäischen Norm EN50067 (Specification of the radio data system RDS) vom April 1992 zu entnehmen.

Dem Stand der Technik entsprechend werden ferner bei Autoradios für das Radio-Daten-System die bei Mehrwegeempfang auftretenden Störsignale ausgewertet, um neben der Beurteilung der Empfangsfeldstärke und etwaiger Nebenkanalstörungen ein Kriterium für das Auslösen eines Empfangsfrequenzwechsels zu haben.

In der DE 3326062 A1 ist ein Detektor zur Anzeige von Empfangsstörungen offenbart, der beim Empfang von UKW-Sendungen besonders Mehrwegeempfangsstörungen erkennen läßt, die von überlagerten Wellen mit starken Laufzeitunterschieden herrühren. Zum Erkennen der Störungen werden die Frequenzstörhubspitzen im ZF-Signal mit Hilfe eines breitbandig arbeitenden Frequenzdemodulators detektiert und durch ein binäres Signal angezeigt. Die Pegelschwelle zur Beurteilung der Störhubspitzen kann abhängig von der zeitlich gemittelten Trägeramplitude eingestellt werden.

Aus der DE 3126224 C2 ist eine Einrichtung zur Detektion von Mehrwegeempfangsstörungen bekannt, bei der die im demodulierten Multiplexsignal enthaltenen Klirranteile der Nutzmodulation erfaßt werden. Da die Verzerrungen modulationsabhängig sind, ändert sich der Störpegel im Rhythmus der NF-Modulation. Demzufolge wird der Wechsel auf eine alternative Empfangsfrequenz zu einem Zeitpunkt ausgelöst, an dem die NF-Aussteuerung besonders hoch ist, was zur Folge hat, daß durch den Pegel- und Phasensprung im NF-Signal ein Knackgeräusch entsteht.

Aufgabe der Erfindung ist es deshalb, einen RDS-Rundfunkempfänger ohne zusätzlichen Hardwareaufwand derart auszubilden, daß beim Auftreten von Mehrwegeempfangsstörungen ein knackfreies Umschalten auf eine alternative Empfangsfrequenz ermöglicht wird.

Diese Aufgabe wird durch einen Rundfunkempfänger mit den Merkmalen des Anspruchs 1 gelöst. Vorteilhafte Ausgestaltungen der Erfindung sind in den Unteransprüchen beschrieben.

Anhand der Zeichnungen wird die Erfindung nachstehend erläutert.

Es zeigen:
- Fig. 1: das Blockschaltbild für ein Ausführungsbeispiel des erfindungsgemäßen Rundfunkempfängers;
- Fig. 2: den zeitlichen Verlauf des Momentanwertes und des errechneten Mittelwertes des Mehrwegestörsignals in Abhängigkeit von der NF-Modulation.

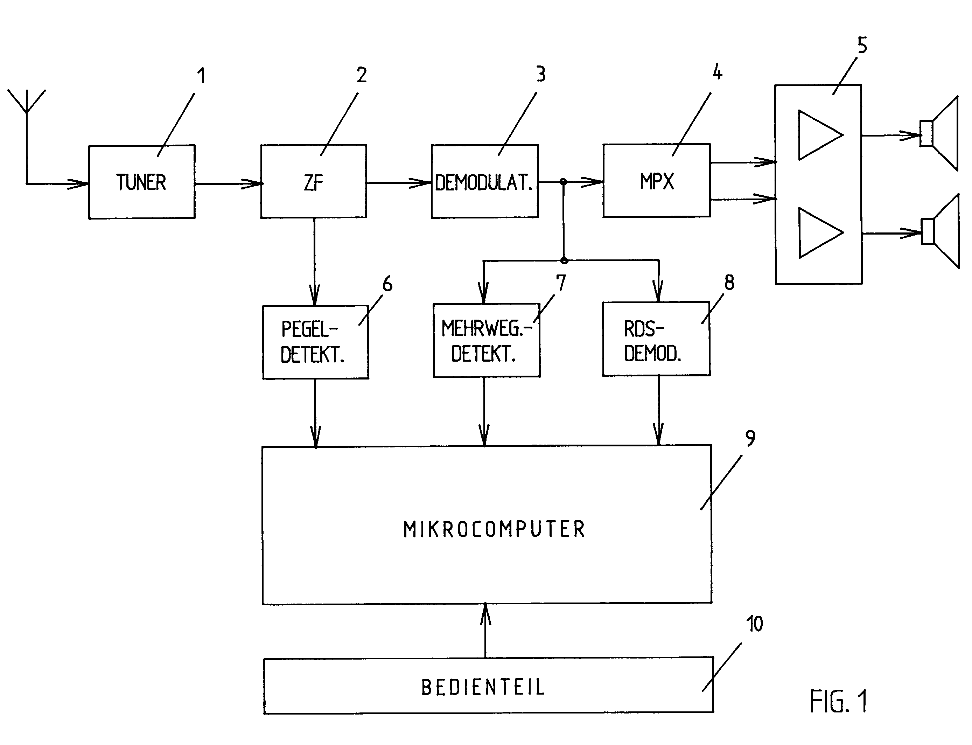

Der in Fig. 1 dargestellte Rundfunkempfänger beinhaltet in an sich bekannter Weise einen Synthesizer-Tuner 1, der über den Mikrocomputer 9 abgestimmt wird, einen ZF-Verstärker 2 zum frequenzselektiven Verstärken des Zwischenfrequenzsignals, einen Demodulator 3, einen Stereodecoder 4 zum Decodieren des demodulierten Multiplexsignals und einen Stereo-Endverstärker 5 zum Betreiben der beiden Lautsprecher. Über den Pegeldetektor 6 wird dem Mikrocomputer 9 nach Maßgabe des ZF-Pegels eine Meßgröße zur Feststellung der Signalfeldstärke übermittelt, während er über den Mehrwegedetektor 7 die dem demodulierten Multiplexsignal entnommenen Störsignale zum Erkennen von Mehrwegeempfang erhält. Da es sich in beiden Fällen um analoge Signale handelt, muß der Mikrocomputer 9 am jeweiligen Eingang zunächst eine Analog-/Digitalwandlung vornehmen. Aus dem demodulierten Multiplexsignal gewinnt außerdem der RDS-Demodulator 8 die digitalen RDS-Daten, die im Mikrocomputer 9 decodiert und weiter ausgewertet werden. Bedien- und Steuerbefehle erhält der Mikrocomputer 9 vom Bedienteil 10.

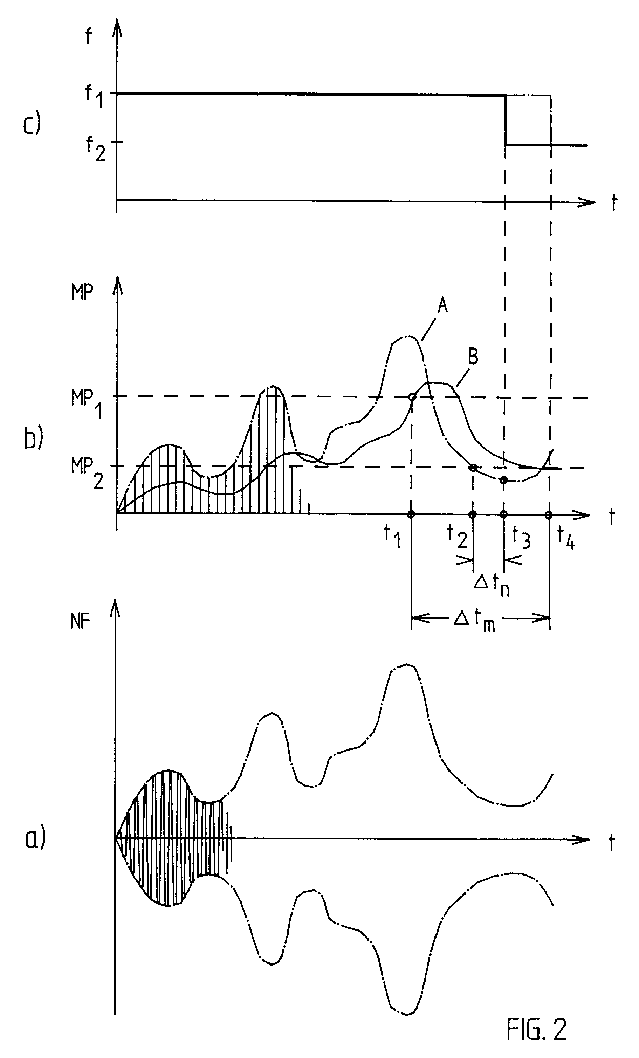

Der Mehrwegedetektor 7 bewertet die Klirrspektren des NF-Nutzsignals oberhalb einer Grenzfrequenz von beispielsweise 75 kHz und weist damit einen genügenden Frequenzabstand zur Hilfsträgerfrequenz von 57 kHz auf, mit der die RDS-Signale übertragen werden. Der zeitliche Verlauf der Momentanwerte dieser Klirrspektren ist in Kurve A der Fig. 2b dargestellt. Wie aus der Fig. 2 ersichtlich, folgt der Amplitudenverlauf der einhüllenden Kurve A dem zeitlichen Verlauf der NF-Modulation in Fig. 2a.

Aus den Momentanwerten der Störspektren in Kurve A errechnet der Mikrocomputer 9 durch zeitliche Integration und besonders bewertete Aufaddition der einzelnen Kurzzeitintegrale sogenannte Langzeit-Mittelwerte, deren Amplitudenverlauf als Funktion der Zeit durch Kurve B in Fig. 2b markiert ist. Diese Mittelwertbildung soll verhindern, daß ein kurzzeitiges Überschreiten der Auslöseschwelle MP₁ durch die Momentanwerte des Störsignals zu einem automatischen Frequenzwechsel des Empfangsgerätes führt.

Überschreitet jedoch die Mittelwertkurve B die vorgegebene Auslöseschwelle MP₁ zum Zeitpunkt t₁, so kontrolliert der Mikrocomputer 9, ob innerhalb der maximalen Zeitspanne Δ tₘ die Amplitude der Momentanwertkurve einen vorgegebenen unteren Grenzwert MP₂ unterläuft. Sobald zum Zeitpunkt t₂ der Amplitudenwert der Kurve A kleiner oder gleich dem Pegelwert MP₂ ist, prüft der Mikroprozessor 9 innerhalb der Mindestzeitdauer Δ tₙ durch beispielsweise 10 Meßvorgänge, ob die Pegelunterschreitung während der Gesamtdauer Δ tₙ erfüllt ist, und gibt bei positivem Ergebnis zum Zeitpunkt t₃ ein neues Abstimmsignal an den Synthesizer-Tuner 1.

Aufgrund der Tatsache, daß nach dem Einleiten des Frequenzwechsels zum Zeitpunkt t₁ der endgültige Umschaltbefehl erst gegeben wird, wenn zum Zeitpunkt t₃ für eine Mindestzeitdauer Δ tₙ der Momentanwert des Störsignals und damit auch der Momentanwert der NF-Modulation einen unteren Grenzwert unterschritten hat, bewirkt, daß der Wechsel der Empfangsfrequenz während einer NF-Signalpause erfolgt und dadurch keine Amplituden- und Phasensprünge am Verstärkerausgang auftreten können, die zu Knackstörungen führen.

Da die maximale Zeitspanne Δ tₘ in praxi beispielsweise auf 800 ms begrenzt ist, kann es vorkommen, daß der Mindestpegel MP₂ vom Momentanwert des Störsignals innerhalb dieses Zeitrahmens nicht unterschritten wird. Um dennoch einen Frequenzwechsel wegen der vorhandenen Mehrwegeempfangsstörungen auszulösen, wird in einer Ausgestaltung der Erfindung nach Erreichen des Zeitpunktes t₄ unabhängig vom weiteren Amplitudenverlauf ein neues Abstimmsignal vom Mikrocomputer 9 an den Tuner 1 geliefert.

Der Wechsel zwischen den Empfangsfrequenzen f₁ und f₂ zum Zeitpunkt t₃ (ausgezogene Linie) bzw. zum Zeitpunkt t₄ (strich-punktierte Linie) ist in Fig. 2c parallel zum zeitlichen Verlauf der Störsignale dargestellt.

In einer weiteren Ausgestaltung der Erfindung wird der untere Schwellwert MP₂ für den Fall, daß der Momentanwert des Störsignals innerhalb der Zeitspanne Δ tₘ den unteren Grenzwert nicht erreicht hat, kontinuierlich so lange angehoben, bis die Bedingungen für die Pegelunterschreitung erfüllt sind. Dadurch wird die maximale Zeitspanne Δ t'ₘ bis zum endgültigen Auslösen des Umschaltbefehls abweichend vom ursprünglich vorgegebenen Wert Δ tₘ entsprechend dem zeitlichen Verlauf der NF-Modulation und der Schwellwertanhebung verlängert.

## Patentansprüche

1. RDS-Rundfunkempfänger, insbesondere RDS-Autoradio, mit einer Einrichtung (7) zum Erkennen von Mehrwegeempfangsstörungen und mit einer als Mikrocomputer ausgebildeten Steuereinheit (9), mit deren Hilfe der Tuner (1) des Empfängers auf eine alternative Frequenz zum Empfang desselben Programms automatisch abgestimmt wird, sobald der Störpegel ein vorgegebenes Maß überschreitet,
**dadurch gekennzeichnet,** daß
der Mikrocomputer (9) den Tuner (1) erst dann auf eine alternative Empfangsfrequenz abstimmt, wenn das aus dem Momentanwertsignal des Mehrwegedetektors (7) vom Mikrocomputer (9) errechnete Mittelwertsignal einen vorgegebenen Schwellwert (MP₁) überschritten und ab diesem Zeitpunkt der Momentanwert des Mehrwegestörsignals innerhalb einer maximalen Zeitspanne (Δ tₘ) einen unteren Grenzwert (MP₂) für eine Mindestzeitdauer (Δ tₙ) unterschritten hat.

2. RDS-Rundfunkempfänger nach Anspruch 1,
**dadurch gekennzeichnet**, daß
der Mikrocomputer (9) den Tuner (1) nach Ablauf der Zeitspanne (Δtₘ) zwangsweise auf eine alternative Frequenz abstimmt, wenn bis dahin der Momentanwert des Mehrwegestörsignals den unteren Grenzwert (MP₂) nicht unterschritten hat.

3. RDS-Rundfunkempfänger nach Anspruch 1,
**dadurch gekennzeichnet**, daß
der Mikrocomputer (9) nach Ablauf der Zeitspanne (Δtₘ) den unteren Grenzwert (MP₂) für das endgültige Umschalten auf eine alternative Empfangsfrequenz kontinuierlich anhebt, wenn bis dahin der Momentanwert des Mehrwegestörsignals den anfänglich vorgegebenen unteren Grenzwert (MP₂) nicht unterschritten hat.

## Claims

1. RDS radio receiver, in particular RDS car radio, having a device (7) for detecting multiple-path reception interference and having a control unit (9) which is designed as a microcomputer and with whose aid the tuner (1) of the receiver is automatically tuned to an alternative frequency for receiving the same programme as soon as the interference level exceeds a specified magnitude, characterized in that the microcomputer (9) first tunes the tuner (1) to an alternative reception frequency if the average signal calculated from the instantaneous value signal of the multiple-path detector (7) of the microcomputer (9) has exceeded a specified threshold value (MP₁) and, from this point in time onwards, the instantaneous value of the multiple-path interference signal has dropped below a lower limit value (MP₂) in the course of a maximum time interval (Δtₘ) for a minimum period of time (Δtₙ).

2. RDS radio receiver according to Claim 1, characterized in that after the time interval (Δtₘ) has elapsed, the microcomputer (9) automatically tunes the tuner (1) to an alternative frequency if, up to that point, the instantaneous value of the multiple-path interference signal has not dropped below the lower limit value (MP₂).

3. RDS radio receiver according to Claim 1, characterized in that, after the time interval (Δtₘ) has elapsed, the microcomputer (9) continuously raises the lower limit value (MP₂) for the ultimate switchover to an alternative reception frequency if, up to that point, the instantaneous value of the multiple-path interference signal has not dropped below the initially specified lower limit value (MP₂).

## Revendications

1. Récepteur radio RDS, notamment autoradio RDS, comportant un dispositif (7) pour identifier des parasites de réception sur canaux multiples et comportant une unité de commande (9), qui est agencée sous la forme d'un micro-ordinateur et à l'aide duquel le tuner (1) du récepteur est accordé automatiquement sur une autre fréquence pour la réception du même programme, dès que le niveau de parasitage dépasse une valeur prédéterminée,
caractérisé en ce que le micro-ordinateur (9) accorde le tuner (1) sur une autre fréquence de réception uniquement lorsque le signal de valeur moyenne, calculé par le micro-ordinateur (9) à partir du signal de valeur instantanée du détecteur à canaux multiples (7) a dépassé une valeur de seuil prédéterminée (MP₁), et qu'à partir de cet instant, la valeur instantanée du signal parasite dans les canaux multiples au cours d'un intervalle de temps maximal (Δtm) est tombée au-dessous d'une valeur limite inférieure (MP₂) pour une durée minimale (Δtn).

2. Récepteur radio RDS selon la revendication 1, caractérisé en ce que le micro-ordinateur (9) accorde d'une manière imposée le tuner (1) sur une autre fréquence, après l'écoulement de l'intervalle de temps (Δtm) lorsque jusqu'à cet instant, la valeur instantanée du signal parasite à canaux multiples n'est pas tombée au-dessous de la valeur limite inférieure (MP₂).

3. Récepteur radio RDS selon la revendication 1, caractérisé en ce qu'après l'écoulement de temps (Δtm), le micro-ordinateur (9) augmente continûment la valeur limite inférieure (MP₂) pour la commutation valable à une autre fréquence de réception, lorsque la valeur instantanée du signal parasite à canaux multiples n'est pas tombée, jusqu'à cet instant, au-dessous de la valeur limite inférieure (MP₂) prédéterminée initialement.
